# EUROPÄISCHE PATENTSCHRIFT

(11) **EP 4 233 098 B1**
(45) Veröffentlichungstag und Bekanntmachung des Hinweises auf die Patenterteilung: **07.08.2024**
(21) Anmeldenummer: 21802220.0
(22) Anmeldetag: 25.10.2021
(51) Int. Cl.: H01L 31/05, H02S 40/30

(54) **SOLARZELLENMODUL**
SOLAR CELL MODULE
MODULE DE CELLULES SOLAIRES

(30) Priorität: 26.10.2020 DE 102020128063
(43) Veröffentlichungstag der Anmeldung: 30.08.2023
(73) Patentinhaber: Fraunhofer-Gesellschaft zur Förderung der angewandten Forschung e.V., 80686 München (DE)
(72) Erfinder: MITTAG, Max, 79110 Freiburg (DE); NEUHAUS, Holger, 79110 Freiburg (DE); KUTTER, Christoph, 79110 Freiburg (DE); ALANIS, Luis Eduardo, 79110 Freiburg (DE)
(74) Vertreter: LBP Lemcke, Brommer & Partner Patentanwälte mbB
(86) Internationale Anmeldenummer: PCT/EP2021/079565
(87) Internationale Veröffentlichungsnummer: WO 2022/090168

(56) Entgegenhaltungen:
- DE-A1- 102009 044 610
- DE-U1- 202012 004 526
- US-A1- 2016 226 439
- WITTECK ROBERT ET AL: "Partial shading of one solar cell in a photovoltaic module with 3-terminal cell interconnection", SOLAR ENERGY MATERIALS AND SOLAR CELLS, ELSEVIER SCIENCE PUBLISHERS, AMSTERDAM, NL, vol. 219, 7 October 2020 (2020-10-07), XP086340575, ISSN: 0927-0248, [retrieved on 20201007], DOI: 10.1016/J.SOLMAT.2020.110811

## Beschreibung

Die Erfindung betrifft ein Solarzellenmodul gemäß Oberbegriff des Anspruchs 1. Solarzellen sind empfindliche Halbleiterbauelemente. Um diese gegen Umwelteinflüsse langzeitbeständig zu schützen und handhabbare elektrische Ausgangsparameter zu erreichen, werden Solarzellen typischerweise elektrisch verschaltet und in einem Modulaufbau eingekapselt.

Problematisch bei der Verwendung von Solarzellenmodulen ist eine Teilabschattung, bei welcher einzelne Solarzellen ganz oder teilweise abgeschattet werden, beispielsweise durch Verschmutzung oder durch Objekte mit Schattenwurf auf das Solarzellenmodul. Bei einer Teilverschattung kann zum einen die elektrische Ausgangsleistung des gesamten Solarzellenmoduls auf null sinken. Zum anderen kann eine Teilverschattung zu einer erheblichen Erwärmung der teilverschatteten Solarzelle führen, sodass das Risiko einer Beschädigung der Solarzelle und des Modulaufbaus besteht. Es ist daher bekannt, Bypassdioden parallel zu mehreren Solarzellen zu verschalten, sodass im Fall einer Teilabschattung in einem Teilbereich des Solarzellenmoduls die Solarzellen in diesem Teilbereich über die Bypassdiode überbrückt werden.

Typischerweise weist ein Solarzellenmodul daher mehrere Modulsegmente auf, wobei jedes Modulsegment mehrere parallel oder seriell verschaltete Solarzellenstrings umfassen kann. Ein Solarzellenstring weist mehrere in Reihe geschaltete Solarzellen auf.

Aus US 2016/0226439 A1 sind unterschiedliche Konfigurationen von Modulsegmenten eines Solarzellenmoduls bekannt, wobei jedem Modulsegment jeweils eine parallel geschaltete Bypassdiode zugeordnet ist.

Aus DE 20 2012 004526 U1 sind Solarzellenmodule bekannt, welche in Reihe geschaltete Stringanordnungen von parallel geschalteten Solarzellen-Strings aufweisen.

Die zunehmende Verwendung von Solarzellen zur Umwandlung von Sonnenlicht in elektrische Energie führt zu einem Bedarf, Solarzellenmodule in auf die jeweilige Verwendung angepasster Größe und Aspektverhältnis von Länge zu Breite des Solarzellenmoduls herzustellen.

Der vorliegenden Erfindung liegt daher die Aufgabe zugrunde, einen Aufbau eines Solarzellenmoduls zur Verfügung zu stellen, welcher die vorbekannte Aufteilung in Modulsegmente, welchen Bypassdioden zugeordnet werden können, beibehält und dennoch eine flexiblere Gestaltung der Form und/oder Fläche des Solarzellenmoduls ermöglicht.

Gelöst ist diese Aufgabe durch ein Solarzellenmodul gemäß Anspruch 1. Vorteilhafte Ausführungsformen finden sich in den abhängigen Ansprüchen.

Das erfindungsgemäße Solarzellenmodul weist eine Mehrzahl von Solarzellenstrings auf, wobei jeder Solarzellenstring eine Mehrzahl in Reihe geschalteter Solarzellen aufweist.

Wesentlich ist, dass das Solarzellenmodul eine Mehrzahl Solarzellen einer Gruppe A und eine Mehrzahl Solarzellenelemente einer Gruppe B aufweist, wobei die Solarzellen der Gruppe A am optimalen Arbeitspunkt einen geringeren Ausgangsstrom aufweisen als die Solarzellenelemente der Gruppe B.

Der optimale Arbeitspunkt einer Solarzelle sowie eines Solarzellenelements wird auch Maximum-Power-Point (MPP) genannt und definiert sich durch diejenige Spannung V_{MPP}, bei welcher die Solarzelle bzw. das Solarzellenelement unter einer Normbeleuchtung eine Stromausgabe mit einer Stromdichte I_{MPP} aufweist, sodass die elektrische Leistung, d. h. das Produkt V_{MPP} * I_{MPP} maximal ist.

Die Normbedingungen hängen von dem gewünschten Anwendungsgebiet des Solarzellenmoduls ab. Für terrestrische Anwendungen wird typischerweise auf die Normbedingungen gemäß "IEC 61853-1 Photovoltaic (PV) module performance testing and energy rating - Part 1: Irradiance and temperature performance measurements and power rating" zurückgegriffen.

Das erfindungsgemäße Solarzellenmodul weist ein erstes Modulsegment auf, mit mehreren parallel geschalteten Solarzellenstrings, wobei jeder Solarzellenstring des ersten Modulsegments aus in Reihe geschalteten Solarzellen der Gruppe A ausgebildet ist. Das Solarzellenmodul weist weiterhin mindestens ein zweites, mit dem ersten Modulsegment in Reihe geschaltetes Modulsegment auf, mit zumindest einem Solarzellenstring B1, welcher mehrere in Reihe geschaltete Solarzellenelemente der Gruppe B aufweist.

Bei Solarzellenmodulen aus dem Stand der Technik werden typischerweise Solarzellen einer einheitlichen Güteklasse, insbesondere mit einer einheitlichen Stromausgabe, unter Normbedingungen verwendet. Dies ist darin begründet, dass bei hintereinandergeschalteten Solarzellen eine Solarzelle mit einer geringeren Ausgangsleistung, insbesondere einer geringeren Stromausgabe, die Ausgangsleistung anderer mit dieser Solarzelle in Reihe geschalteter Solarzellen, welche grundsätzlich für eine höhere Ausgangsleistung geeignet sind, begrenzt. Der hierdurch entstehende Verlust wird als Current Mismatch bezeichnet.

Das erfindungsgemäße Solarzellenmodul weist hingegen sowohl Solarzellen der Gruppe A als auch Solarzellenelemente der Gruppe B auf, welche somit unterschiedliche Ausgangsströme aufweisen. Aufgrund der Verwendung dieser Solarzellen und Solarzellenelemente in verschiedenen, in Reihe geschalteten Modulsegmenten, ergibt sich eine erhöhte Flexibilität bei der Konfiguration des Solarzellenmoduls, insbesondere hinsichtlich der möglichen Flächen und Aspektverhältnisse der einzelnen Modulsegmente und des gesamten Solarzellenmoduls, wobei gleichzeitig der grundsätzliche Aufbau mit Unterteilung des Solarzellenmoduls in verschiedene Modulsegmente beibehalten wird, sodass beispielsweise eine Parallelschaltung von Bypasselementen, insbesondere Bypassdioden in an sich bekannter Weise möglich ist und darüber hinaus eine Verschaltung mit kürzeren Leiterwegen und geringerem Materialaufwand möglich ist.

Aufgrund der Reihenschaltung des ersten und des zweiten Modulsegments weicht vorteilhafterweise der Ausgangsstrom des ersten Modulsegments unter Normbedingungen nur geringfügig, insbesondere bevorzugt um weniger als 2 %, weiter bevorzugt um weniger als 0,5 %, insbesondere um weniger als 0,1 % von dem Ausgangsstrom des zweiten Modulsegments unter Normbedingungen ab. Hierdurch wird ein Current Mismatch zwischen erstem und zweitem Modulsegment und ein hierauf basierender Verlust somit vermieden oder zumindest erheblich verringert.

Aufgrund des geringeren Ausgangsstroms der Solarzellen in Gruppe A gegenüber der Solarzellenelemente in Gruppe B ist es vorteilhaft, dass das erste Modulsegment eine größere Anzahl von parallel geschalteten Solarzellenstrings aufweist gegenüber dem zweiten Modulsegment, insbesondere bevorzugt derart, dass die Ausgangsströme von ersten und zweiten Modulsegment sich wie zuvor beschrieben um weniger als 2 %, bevorzugt um weniger als 0,5 %, insbesondere weniger als 0,1 %, unterscheiden.

Es liegt im Rahmen der Erfindung, dass das zweite Modulsegment Solarzellenstrings mit Solarzellen aufweist, welche einen geringeren Ausgangsstrom gegenüber den Solarzellen der Gruppe A aufweisen. In diesem Fall kann auch bei gleicher Anzahl von Solarzellenstrings im ersten wie im zweiten Modulsegment ein Current Mismatch vermieden werden.

Es ist jedoch insbesondere zur Verringerung des Fertigungsaufwands vorteilhaft, dass das zweite Modulsegment ausschließlich Solarzellenelemente der Gruppe B aufweist. In diesem Fall ist es wie zuvor beschrieben vorteilhaft, dass das erste Modulsegment eine größere Anzahl parallel geschalteter Solarzellenstrings aufweist verglichen mit dem zweiten Modulsegment, um einen Current Mismatch zwischen erstem und zweitem Modulsegment zu vermeiden oder zumindest zu verringern.

In einer vorteilhaften Ausführungsform weist Gruppe B als Solarzelle ausgebildete Solarzellenelemente auf, wobei jedes dieser Solarzellenelemente eine größere aktive Solarzellenfläche gegenüber der aktiven Fläche jeder der Solarzellen der Gruppe A aufweist. Diese derart als Solarzelle ausgebildeten Solarzellenelemente der Gruppe B weisen somit aufgrund der größeren aktiven Fläche einen größeren Ausgangsstrom auf, gegenüber den Solarzellen der Gruppe A mit geringerer aktiver Fläche.

Solarzellen werden mit zunehmend größeren aktiven Flächen hergestellt. Es ist daher bekannt, Solarzellenmodule aus Teilsolarzellen auszubilden. Typischerweise werden Solarzellen in zwei Teilsolarzellen mit jeweils hälftiger aktiver Fläche der Gesamtsolarzelle aufgeteilt. Diese Teilsolarzellen werden entsprechend auch als Halbsolarzellen bezeichnet.

Das erfindungsgemäße Solarzellenmodul ermöglicht die Verwendung von Teilsolarzellen, insbesondere Halbsolarzellen, zusammen mit ungeteilten Solarzellen in einem Modul, wobei die Teilsolarzellen, insbesondere bevorzugt die Halbsolarzellen, der Gruppe A zugeordnet sind und die ungeteilten Solarzellen mit der ursprünglichen aktiven Fläche der Gruppe B zugeordnet sind.

Hierdurch ergibt sich die vorbeschriebene Flexibilität hinsichtlich der Form und des Aspektverhältnisses des Solarzellenmoduls. Ebenso können ästhetisch abwechslungsreiche Anordnungen erzielt werden.

Es ist daher insbesondere vorteilhaft, dass jedes der Solarzellenelemente der Gruppe B wie zuvor beschrieben als Solarzelle mit einer größeren aktiven Solarzellenfläche gegenüber der aktiven Fläche jeder der Solarzellen der Gruppe A ausgebildet ist.

In einer weiteren vorteilhaften Ausführungsform weist die Gruppe B Solarzellenelemente auf, welche als Parallelschaltung mehrerer Solarzellen ausgebildet sind, wobei für jedes dieser Solarzellenelemente die Summe der aktiven Fläche der parallel geschalteten Solarzellen größer ist als die aktive Fläche jeder der Solarzellen der Gruppe A. Solarzellenstring B1 weist zumindest ein derart ausgebildetes Solarzellenelement auf. Bevorzugt weist Solarzellenstring B1 ausschließlich derart ausgebildete Solarzellenelemente auf. Insbesondere weist bevorzugt das zweite Modulsegment ausschließlich derart ausgebildete Solarzellenelemente auf.

Bei dieser vorteilhaften Ausgestaltung ist es somit nicht zwingend notwendig, Solarzellen mit unterschiedlich großen aktiven Teilflächen wie beispielsweise Teilsolarzellen und ungeteilte Solarzellen zu verwenden. Bei dieser vorteilhaften Ausführungsform kann hingegen einheitlich ein Solarzellentyp, insbesondere mit identischer Größe der aktiven Solarzellenfläche, verwendet werden. Die Solarzellenelemente der Gruppe B weisen einen größeren Ausgangsstrom auf, da mehrere Solarzellen in einem Mikronetzwerk parallel verschaltet sind, sodass das Solarzellenelement, welches aus mehreren parallel verschalteten Solarzellen besteht, einen Ausgangsstrom aufweist, welcher in etwa einer Solarzelle mit einer aktiven Fläche entspricht, welche die Summe der aktiven Flächen der parallel geschalteten Solarzellen beträgt.

Das erste Modulsegment weist zumindest zwei parallel geschaltete Solarzellenstrings auf. Das zweite Modulsegment kann lediglich einen Solarzellenstring oder mehrere parallel geschaltete Solarzellenstrings aufweisen. Zur Vereinheitlichung der Definitionen wird im Folgenden mit "Anzahl 1" von parallel geschalteten Strings oder vergleichbaren Formulierungen die Ausgestaltung eines Modulsegments mit lediglich einem Solarzellenstring beschrieben.

Es ist vorteilhaft, dass die Solarzellenelemente der Gruppe B einen Ausgangsstrom aufweisen, welcher ein ganzzahliges Vielfaches des Ausgangsstroms der Solarzellen der Gruppe A entspricht. Insbesondere ist es vorteilhaft, dass alle Solarzellenelemente der Gruppe A im Wesentlichen einen identischen Ausgangsstrom aufweisen und alle Solarzellenelemente der Gruppe B einen identischen Ausgangsstrom aufweisen.

Für den vorbeschriebenen vorteilhaften Fall, dass der Ausgangsstrom der Solarzellenelemente der Gruppe B einem ganzzahliges Vielfaches V, insbesondere bevorzugt das Doppelte, das Dreifache oder Vierfache des Ausgangsstroms der Solarzellen der Gruppe A entspricht, kann in einer vorteilhaften Ausgestaltung ein Current Mismatch vermieden werden, indem bei einer Anzahl *m* (*m* = 1,2,3,...) von parallelgeschalteten Solarzellenstrings im zweiten Modulsegment eine Anzahl V*m Solarzellenstrings in dem ersten Modulsegment parallel geschaltet wird.

Beträgt beispielsweise der Ausgangsstrom eines Solarzellenelements der Gruppe B das Dreifache des Ausgangsstroms einer Solarzelle der Gruppe A (*V* = 3) und weist das zweite Modulsegment lediglich einen Solarzellenstring auf (m = 1), so sind bevorzugt in dem ersten Modulsegment 3*1 = 3 Solarzellenstrings parallelgeschaltet. Weist das zweite Modulsegment in einer Abwandlung beispielsweise 2 (m = 2) parallel geschaltete Solarzellenstrings auf, so weist das erste Modulsegment bevorzugt 3*2 = 6 parallel geschaltete Solarzellenstrings auf.

Die Solarzellen des Solarzellenstrings B1 sind bevorzugt in einer geradlinigen Reihe angeordnet. Hierdurch ergeben sich Vorteile bei der Verwendung an sich bekannter Fertigungsmethoden für Solarzellenmodule, welche für geradlinige Solarzellenstrings ausgebildet sind. Insbesondere ist es daher vorteilhaft, bei Ausgestaltung eines, mehrerer oder aller Solarzellenelemente der Gruppe B durch Parallelverschaltung mehrerer Solarzellen, auch die parallel geschalteten Solarzellen eines Solarzellenelementes entlang der geradlinigen Linie des Solarzellenstrings anzuordnen.

Zur Reduzierung von Abschattungsverlusten ist es vorteilhaft, dass das Solarzellenmodul zumindest ein erstes Bypasselement aufweist und das erste Bypasselement parallel zu den in Reihe geschalteten ersten und zweiten Modulsegmenten geschaltet ist. Im Gegensatz zu typischen Konfigurationen ist bei dieser vorteilhaften Ausgestaltung somit ein Bypasselement zwei in Reihe geschalteten Modulsegmenten, vorliegend dem ersten und dem zweiten Modulsegment, parallel geschaltet. Hierdurch ergeben sich neben dem Vorteil der Einsparung von Bypasselementen Vorteile bei der räumlichen Anordnung der Bypasselemente, wie nachfolgend anhand weiterer bevorzugter Ausführungsformen erläutert:
Die Bypasselemente können in an sich bekannterweise ausgebildet sein, insbesondere liegt auch die Ausbildung der Bypassdioden als Dioden, insbesondere Schottkydioden, als MOSFETs oder als elektronische Schalteinrichtung und/oder integrierte Schaltungen, insbesondere gemäß

DE 102005012213 A1 und/oder DE 10 2009 060 604 A1 im Rahmen der Erfindung.

Vorteilhafterweise weist das Solarzellenmodul ein Laminat auf, in welche zumindest ein, bevorzugt alle Bypasselemente integriert sind.

Vorteilhafterweise sind das erste und das zweite Modulsegment nebeneinander angeordnet und an einem ersten Randbereich elektrisch in Reihe geschaltet. Insbesondere ist es konstruktiv einfach, an diesem ersten Randbereich das erste und das zweite Modulsegment mittels eines Querverbinders, bevorzugt mittels eines geradlinigen Querverbinders, in Reihe zu schalten.

Diese Anordnung ergibt den Vorteil, dass die weitere Verschaltung der beiden Modulsegmente an dem genannten Randbereich, insbesondere dem genannten Querverbinder gegenüberliegenden Randbereich erfolgen kann.

Insbesondere ist es vorteilhaft, dass das erste Bypasselement an einem dem ersten Randbereich gegenüberliegenden zweiten Randbereich angeordnet ist. Hierdurch ergeben sich gegenüber vorbekannten Konfigurationen kürzere Verbindungswege zur Parallelschaltung des Bypasselements.

In einer vorteilhaften Weiterbildung ist das erste Bypasselement an einem Endbereich des zweiten Modulsegments angeordnet.

Wie zuvor beschrieben, weisen die Solarzellenelemente der Gruppe B einen höheren Ausgangsstrom gegenüber den Solarzellen der Gruppe A auf. Typischerweise werden die Solarzellenstrings des zweiten Modulsegments daher mit einer geringeren Gesamtfläche an Zwischenräumen zwischen den Solarzellen des zweiten Solarzellenelementes innerhalb eines Strings ausgebildet, sodass die Solarzellenstrings des zweiten Modulsegments kürzer ausgebildet werden können, verglichen mit den Solarzellenstrings des ersten Modulsegments. In vorteilhafter Weise wird nun bei der vorgenannten vorteilhaften Weiterbildung die verbleibende Fläche, welche sich aus der Längendifferenz zwischen dem ersten und dem zweiten Modulsegment ergibt, zur Anordnung des Bypasselements verwendet, indem das erste Bypasselement an einem Endbereich des zweiten Modulsegments angeordnet ist.

Es liegt im Rahmen der Erfindung, dass das Solarzellenmodul lediglich die zwei vorgenannten Modulsegmente aufweist. Eine Skalierung des Solarzellenmoduls ist insbesondere durch die Anzahl von Solarzellen bzw. Solarzellenelementen in dem ersten und zweiten Modulsegment möglich, insbesondere durch die Anzahl von Solarzellen pro Solarzellenstrings eines Modulsegments.

Ebenso liegt es im Rahmen der Erfindung, dass das Solarzellenmodul weitere Modulsegmente aufweist. Insbesondere ist es vorteilhaft, dass das Solarzellenmodul ein oder mehrere Paare weiterer Modulsegmente aufweist, wobei jedes Paar von Modulsegmenten jeweils ein analog des ersten Modulsegments und ein analog des zweiten Modulsegments ausgebildetes Modulsegment aufweist.

In einer vorteilhaften Ausgestaltung weist das Solarzellenmodul daher zumindest ein drittes und ein mit dem dritten Modulsegment in Reihe geschaltetes viertes Modulsegment auf, wobei das dritte Modulsegment mehrere parallel geschaltete Solarzellenstrings aufweist, wobei jeder Solarzellenstring des dritten Modulsegments aus in Reihe geschalteten Solarzellen der Gruppe A ausgebildet ist und das vierte Modulsegment zumindest ein Solarzellenstring B2 aufweist, welcher mehrere in Reihe geschaltete Solarzellenelemente der Gruppe B aufweist. Das Solarzellenmodul weist weiterhin zumindest ein zweites Bypasselement auf, welches parallel zu den in Reihe geschalteten dritten und viertens Modulsegmenten geschaltet ist. Das zweite Bypasselement ist an einem Endbereich des vierten Modulsegments angeordnet.

Hierdurch ergeben sich auch bei dem zweiten Bypasselement die vorgenannten Vorteile hinsichtlich der Flächenausnutzung.

In einer vorteilhaften Weiterbildung sind das zweite und das vierte Modulsegment und das erste und das dritte Modulsegment jeweils gegenüberliegend zu einer Mittellinie der vier Modulsegmente angeordnet und das erste und das zweite Bypasselement sind zwischen zweitem und viertem Modulsegment angeordnet. Hierdurch ergibt sich eine besonders flächeneffiziente Anordnung.

In einer alternativen vorteilhaften Weiterbildung sind die vier Modulsegmente in Reihe in der Reihenfolge erstes Modulsegment, zweites Modulsegment, viertes Modulsegment, drittes Modulsegment nebeneinanderliegend angeordnet und das erste und das zweite Bypasselement sind an einem gemeinsamen Endbereich des zweiten und des vierten Modulsegments angeordnet. Hierdurch ergibt sich die platzsparende Anordnung sowie die Notwendigkeit lediglich kurzer Verbindungswege zur Verschaltung der Bypasselemente.

In einer weiteren alternativen vorteilhaften Weiterbildung sind die vier Modulsegmente in einer Reihe in der Reihenfolge zweites Modulsegment, erstes Modulsegment, drittes Modulsegment, viertes Modulsegment nebeneinanderliegend angeordnet und das erste Bypasselement ist an einem Endbereich des zweiten Modulsegments und das zweite Bypasselement an einem Endbereich des vierten Modulsegments angeordnet. Hierdurch ergibt sich der Vorteil, dass die Anschlussdosen näher am Modulrand platziert werden können und die externe Verkabelung reduziert werden kann.

Weitere vorteilhafte Merkmale und Ausführungsformen werden im Folgenden anhand von Ausführungsbeispielen und den Figuren erläutert.

Die Figuren zeigen schematische, nicht maßstabsgetreue Darstellungen. Gleiche Bezugszeichen in den Figuren bezeichnen gleiche oder gleich wirkende Elemente.

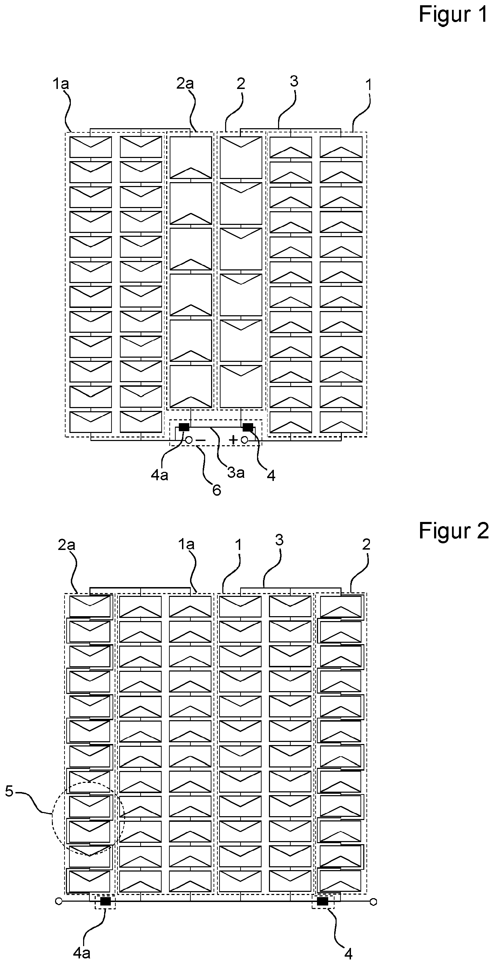

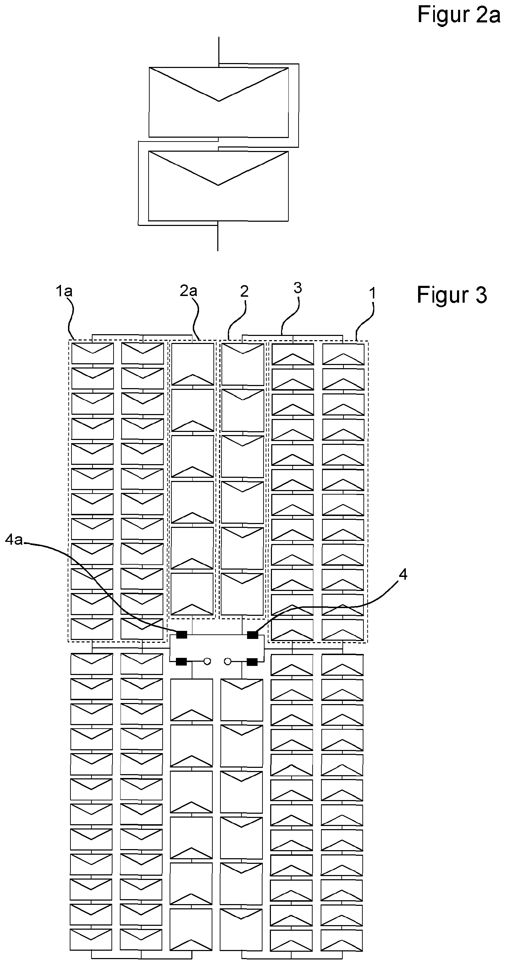

In den Figuren 1 bis 6 ist jeweils ein Ausführungsbeispiel eines erfindungsgemäßen Solarzellenmoduls dargestellt. Figur 2a zeigt einen Detailausschnitt aus Figur 2.

Das in Figur 1 dargestellte Ausführungsbeispiel weist ein erstes Modulsegment 1 und ein zweites Modulsegment 2 auf. Das erste Modulsegment 1 weist zwei parallel geschaltete Solarzellenstrings auf, das zweite Modulsegment 2 lediglich einen Solarzellenstring B1. Mittels eines ersten Querverbinders 3 sind sowohl die beiden Solarzellenstrings des ersten Modulsegments 1 parallel geschaltet, als auch das erste Modulsegment 1 mit dem zweiten Modulsegment 2 in Reihe geschaltet.

Bei den in den Figuren dargestellten Ausführungsbeispielen werden Solarzellen des gleichen Typs verwendet, wobei die Solarzellen teilweise als Gesamtsolarzelle in ihrer ursprünglichen Form, insbesondere quadratischen oder pseudoquadratischen ("pseudo- square") Form oder teilweise als Teilsolarzelle, vorliegend als Halbsolarzelle verwendet werden, welche die Hälfte der aktiven Fläche der Gesamtsolarzelle aufweist. Die Solarzellen als Diodenbauelemente sind jeweils als Quadrat bzw. Rechteck dargestellt, wobei ein Pfeil die Durchlassrichtung der Solarzelle kennzeichnet.

Bei dem in Figur 1 dargestellten Ausführungsbeispiel werden somit für das erste Modulsegment 1 Solarzellen einer Gruppe A verwendet, welche die halbe aktive Fläche der Solarzellen einer Gruppe B aufweisen. Die Solarzellen der Gruppe B mit der doppelten aktiven Fläche gegenüber den Solarzellen der Gruppe A werden für das zweite Modulsegment 2 verwendet.

Die Solarzellen der Gruppe B weisen somit am optimalen Arbeitspunkt, vorliegend unter terrestrischen Normbedingungen, einen höheren Ausgangsstrom gegenüber den Solarzellen der Gruppe A auf. Aufgrund der doppelten aktiven Fläche der Solarzellen der Gruppe B gegenüber den Solarzellen der Gruppe A beträgt der Ausgangsstrom der Solarzellen der Gruppe B in etwa ein ganzzahliges Vielfaches, vorliegend einen Faktor 2 des Ausgangsstroms der Solarzellen der Gruppe A.

Dieser Faktor 2 findet sich ebenso in der Anzahl der parallel geschalteten Strings wieder: Das erste Modulsegment 1 weist doppelt so viele (vorliegend zwei) parallel geschaltetes und Solarzellenstrings auf gegenüber dem zweiten Modulsegment 2 (ein Solarzellenstring). Hierdurch weist das erste Modulsegment insgesamt in etwa einen gleichen Ausgangsstrom auf wie das zweite Modulsegment, sodass sich auch bei Reihenschaltung von erstem Modulsegment 1 und zweiten Modulsegment 2 kein oder nur ein geringfügiger Current Mismatch ergibt.

Die Solarzellen aller Solarzellenstrings von erstem Modulsegment 1 und zweitem Modulsegment 2 sind entlang einer geradlinigen Reihe angeordnet.

Das Solarzellenmodul weist eine erstes, als Bypassdiode ausgebildetes Bypasselement 4 auf, welche parallel zu den in Reihe geschalteten ersten und zweiten Modulsegmenten geschaltet ist. Das erste und das zweite Modulsegment (1, 2) sind nebeneinander angeordnet und an einem ersten Randbereich, vorliegend der in Figur 1 oben dargestellte Randbereich, sind die Modulsegmente wie zuvor beschrieben mittels des ersten Querverbinders 3, welcher als geradliniger Querverbinder ausgebildet ist, elektrisch in Reihe geschaltet.

Das erste Bypasselement 4 ist an einem dem ersten Randbereich gegenüberliegenden zweiten Randbereich angeordnet, welcher gemäß der Darstellung in Figur 1 unten liegend dargestellt ist.

Weiterhin ist das erste Bypasselement 4 an einem Endbereich des zweiten Modulsegments 2 angeordnet.

Wie in Figur 1 ersichtlich, weisen die Solarzellenstrings des ersten Modulsegments 1 die doppelte Anzahl (vorliegend zwölf) an Solarzellen auf, verglichen mit der Anzahl an Solarzellen des Solarzellenstrings des zweiten Modulsegments 2 (vorliegend sechs Solarzellen).

Entsprechend werden für den Solarzellenstring B1 des zweiten Modulsegments 2 weniger Zwischenräume benötigt, sodass der Solarzellenstring B1 des zweiten Modulsegments 2 kürzer ist als die Solarzellenstrings des ersten Modulsegments 1.

Die Solarzellen von erstem und zweitem Modulsegment sind am oberen Rand im Bereich des Querverbinders 3 auf gleicher Höhe angeordnet, sodass sich aufgrund der Längendifferenz der Solarzellenstrings am in Figur 1 unten liegenden Randbereich eine freie Fläche unterhalb des Solarzellenstrings B1 ergibt. An dieser freien Fläche ist das erste Bypasselement 4 angeordnet.

Hierdurch kann der durch die Längendifferenz entstandene Raum für die Querverschaltung mittels Querverbinder 3a von Segment 2 und 2a sowie das Bypasselement verwendet werden. Darüber hinaus sind zur Parallelschaltung des ersten Bypasselements 4 lediglich kurze elektrische Verbindungen notwendig. Hierdurch können der positive und negative Kontakt zur Verschaltung des Moduls sowie die Bypasselemente 4 und 4a in einer gemeinsamen Anschlussdose 6 vorliegend auf der Rückseite des Solarzellenmoduls angeordnet werden. Ebenso liegt es im Rahmen der Erfindung, in einer Abwandlung des Ausführungsbeispiels mehrere Anschlussdosen vorzusehen, insbesondere die beiden Kontakte zur Verschaltung des Modules in verschiedenen Anschlussdosen anzuordnen.

Das Solarzellenmodul gemäß Figur 1 weist weiterhin ein drittes Modulsegment 1a und ein mit dem dritten Modulsegment 1a in Reihe geschaltetes viertes Modulsegment 2a auf.

Analog zu dem ersten Modulsegment 1 weist das dritte Modulsegment 1a mehrere parallel geschaltete Solarzellenstrings auf, wobei jeder Solarzellenstring des Drittmittelsegments aus in Reihe geschalteten Solarzellen der Gruppe A ausgebildet ist und das vierte Modulsegment 2a u weist analog zu dem zweiten Modulsegment 2 einen Solarzellenstring B2 auf, welcher mehrere in Reihe geschaltete Solarzellenelemente der Gruppe B aufweist.

Das Solarzellenmodul weist zudem ein zweites, als Bypassdiode ausgebildetes Bypasselement 4a auf, welche parallel zu den in Reihe geschalteten dritten und vierten Modulsegmenten (1a, 2a) geschaltet ist. Das zweite Bypasselement 4a ist an einem Endbereich des vierten Modulsegments 2a angeordnet.

Wie in Figur 1 ersichtlich, ist das Solarzellenmodul spiegelbildlich zu einer in Figur 1 senkrecht stehenden mittigen Spiegelebene zwischen dem zweiten Modulsegment 2 und vierten Modulsegment 2a ausgebildet. Hierdurch ergeben sich kurze Leitungswege bei der Verschaltung der Bypasselemente 4 und 4a.

Zu den in den weiteren Figuren dargestellten Ausführungsbeispielen wird zur Vermeidung von Wiederholungen nachfolgend lediglich auf die wesentlichen Unterschiede zu dem in Figur 1 dargestellten Ausführungsbeispiel eingegangen:
Das in Figur 2 dargestellte Ausführungsbeispiel weist ein erstes Modulsegment 1 und ein drittes Modulsegment 1a auf, welche analog zu dem in Figur 1 dargestellten Ausführungsbeispiel ausgebildet sind.

Die Solarzellenelemente des zweiten Modulsegments 2 und des vierten Modulsegments 2a sind bei dem in Figur 2 dargestellten Ausführungsbeispiel jedoch jeweils als zwei parallel geschaltete Halbsolarzellen ausgebildet. Exemplarisch ist ein Solarzellenelement 5 des vierten Modulsegments 2a gekennzeichnet. In Figur 2a ist als Detailansicht die Ausbildung der Solarzellenelemente des zweiten Modulsegments 2 und des vierten Modulsegments 2a und somit insbesondere des Solarzellenelements 5 gezeigt.

Wie in Figur 2a ersichtlich, sind die Solarzellenelemente aus zwei Halbzellen ausgebildet, welche untereinander entlang einer geradlinigen Linie, entlang welcher der Solarzellenstring ausgebildet ist, angeordnet sind. Die Solarzellen des Solarzellenelementes sind jedoch nicht in Reihe, sondern parallel verschaltet. Ein solches Solarzellenelement 5 gemäß Figur 2a weist somit den doppelten Ausgangsstrom gegenüber einer Halbsolarzelle auf.

Wie in Figur 2 am unteren Rand ersichtlich, sind im Unterschied zur Figur 1 die Bypasselemente 4 und 4a im äußeren, unteren Bereich des Solarzellenmoduls angeordnet.

In Figur 3 ist ein weiteres Ausführungsbeispiel dargestellt, welches dem Ausführungsbeispiel in Figur 1 entspricht, welches nochmals an einer in Figur 1 unten liegenden, waagrechten Spiegelebene gespiegelt wurde, sodass das in Figur 3 dargestellte Ausführungsbeispiel insgesamt vier Modulsegmente aufweist, welche analog zu dem ersten Modulsegment und vier Modulsegmente, welche analog zu dem zweiten Modulsegment ausgebildet sind, aufweist und entsprechend vier Bypasselemente.

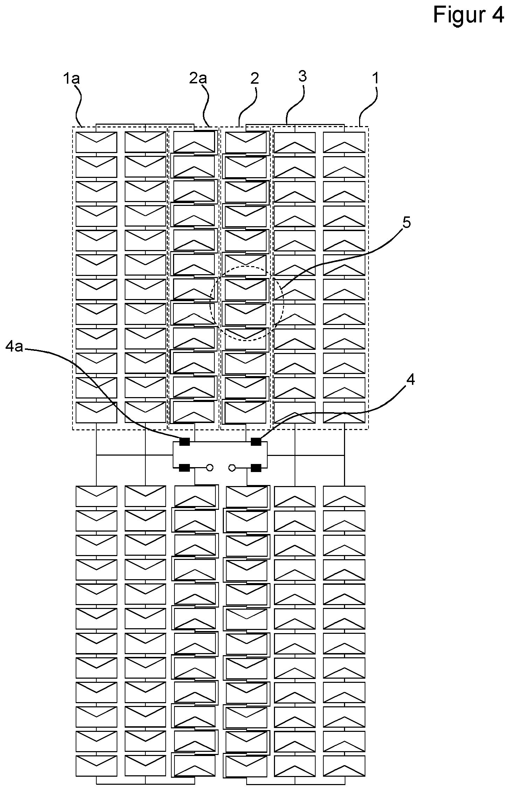

Das in Figur 4 dargestellte Ausführungsbeispiel entspricht einer Dopplung des in Figur 2 dargestellten Ausführungsbeispiels, wobei die Bypasselemente und die Modulsegmente, welche analog zu dem ersten Modulsegment ausgebildet sind, bei dem in Figur 4 dargestellten Ausführungsbeispiel innenliegend angeordnet sind.

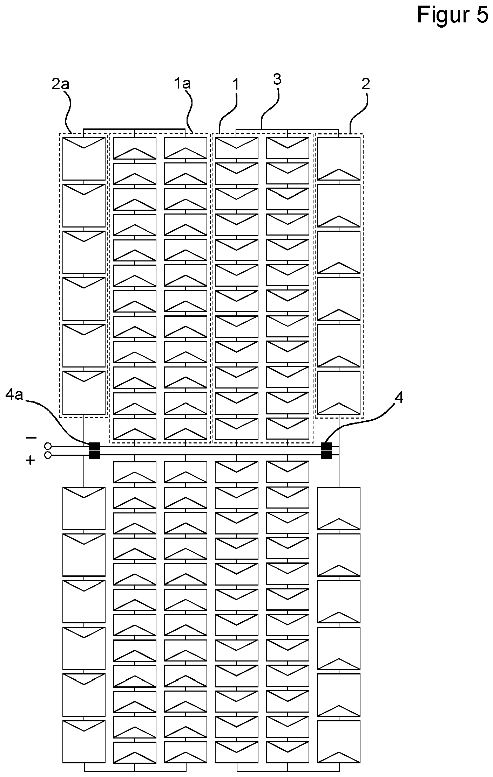

Das Ausführungsbeispiel gemäß Figur 5 stellt eine Abwandlung des in Figur 3 dargestellten Ausführungsbeispiels dar, wobei die dem ersten Modulsegment entsprechenden Modulsegmente jeweils außen liegend angeordnet sind und entsprechend auch die vier Bypasselemente an äußeren Bereichen des Solarzellenmoduls angeordnet sind.

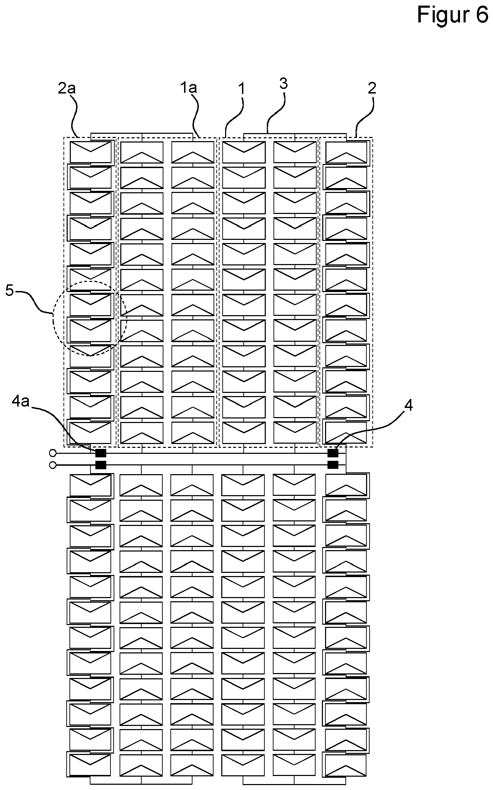

Figur 6 zeigt schließlich ein Ausführungsbeispiel, welches durch Doppelung des in Figur 2 dargestellten Ausführungsbeispiels mit einer waagrechten Spiegelebene am unteren Rand des in Figur 2 dargestellten Ausführungsbeispiels ausgebildet ist.

### Bezugszeichenliste

| | |
|---|---|
| erstes Modulsegment | 1 |
| zweites Modulsegment | 2 |
| erster Querverbinder | 3 |
| Querverbinder | 3a |
| erstes Bypasselement | 4 |
| drittes Modulsegment | 1a |
| viertes Modulsegment | 2a |
| zweites Bypasselement | 4a |
| Solarzellenelement | 5 |
| Anschlussdose | 6 |

## Patentansprüche

1. Solarzellenmodul,
mit Mehrzahl von Solarzellenstrings, wobei jeder Solarzellenstring eine Mehrzahl in Reihe geschalteter Solarzellen aufweist,
**dadurch gekennzeichnet,**
**dass** das Solarzellenmodul eine Mehrzahl Solarzellen einer Gruppe A und eine Mehrzahl Solarzellenelemente einer Gruppe B aufweist, wobei die Solarzellen der Gruppe A am optimalen Arbeitspunkt einen geringeren Ausgangsstrom aufweisen als die Solarzellenelemente der Gruppe B, dass das Solarzellenmodul ein erstes Modulsegment (1) aufweist, mit mehreren parallel geschalteten Solarzellenstrings, wobei jeder Solarzellenstring des ersten Modulsegments (1) aus in Reihe geschalteten Solarzellen der Gruppe A ausgebildet ist und
das Solarzellenmodul mindestens ein zweites, mit dem ersten Modulsegment (1) in Reihe geschaltetes Modulsegment (2) aufweist, mit zumindest einem Solarzellenstring B1, welcher mehrere in Reihe geschaltete Solarzellenelemente der Gruppe B aufweist.

2. Solarzellenmodul nach Anspruch 1,
**dadurch gekennzeichnet,**
**dass** Gruppe B als Solarzelle ausgebildete Solarzellenelemente (5) aufweist, wobei jedes dieser Solarzellenelemente (5) eine größere aktive Solarzellenfläche gegenüber der aktiven Fläche jeder der Solarzellen der Gruppe A aufweist, insbesondere, dass jedes der Solarzellenelemente (5) der Gruppe B derart ausgebildet ist.

3. Solarzellenmodul nach einem der vorangegangenen Ansprüche,
**dadurch gekennzeichnet,**
**dass** Gruppe B Solarzellenelemente (5) aufweist, welche als Parallelschaltung mehrerer Solarzellen ausgebildet sind, wobei für jedes dieser Solarzellenelemente (5) die Summe der aktiven Flächen der parallel geschalteten Solarzellen größer ist als die aktive Fläche jeder der Solarzellen der Gruppe A, wobei Solarzellenstring B1 zumindest ein derart ausgebildetes Solarzellenelement (5) aufweist, insbesondere, dass jedes der Solarzellenelemente (5) des Solarzellenstrings B1, bevorzugt jedes Solarzellenelement (5) der Gruppe B derart ausgebildet ist.

4. Solarzellenmodul nach Anspruch 3,
**dadurch gekennzeichnet,**
**dass** die Solarzellen des Solarzellenstrings B1 entlang in einer geradlinigen Reihe angeordnet sind.

5. Solarzellenmodul nach einem der vorangegangenen Ansprüche,
**dadurch gekennzeichnet,**
**dass** das Solarzellenmodul zumindest ein erstes Bypasselement (4) aufweist und das erste Bypasselement (4) parallel zu den in Reihe geschalteten ersten und zweiten Modulsegmenten (1, 2) geschaltet ist.

6. Solarzellenmodul nach einem der vorangegangenen Ansprüche,
**dadurch gekennzeichnet,**
**dass** das erste und zweite Modulsegment (1, 2) nebeneinander angeordnet sind und an einem ersten Randbereich elektrisch in Reihe geschaltet sind, insbesondere mittels eines Querverbinders (3), bevorzugt mittels eines geradlinigen Querverbinders (3).

7. Solarzellenmodul nach den Ansprüchen 5 und 6,
**dadurch gekennzeichnet,**
**dass** das erste Bypasselement (4) an einem dem ersten Randbereich gegenüberliegenden zweiten Randbereich angeordnet ist.

8. Solarzellenmodul nach den Ansprüchen 5 bis 7,
**dadurch gekennzeichnet,**
**dass** das erste Bypasselement (4) an einem Endbereich des zweiten Modulsegments (2) angeordnet ist.

9. Solarzellenmodul nach einem der vorangegangenen Ansprüche,
**dadurch gekennzeichnet,**
**dass** das Solarzellenmodul zumindest ein drittes und ein mit dem dritten Modulsegment (1a) in Reihe geschaltetes viertes Modulsegment (2a) aufweist, wobei das dritte Modulsegment (1a) mehrere parallel geschalteten Solarzellenstrings aufweist, wobei jeder Solarzellenstring des dritten Modulsegments (1a) aus in Reihe geschalteten Solarzellen der Gruppe A ausgebildet ist und das vierte Modulsegment (2a) zumindest einen Solarzellenstring B2 aufweist, welcher mehrere in Reihe geschaltete Solarzellenelemente (5) der Gruppe B aufweist, dass das Solarzellenmodul zumindest ein zweites Bypasselement (4a) aufweist, welche parallel zu den in Reihe geschalteten dritten und vierten Modulsegmenten (1a, 2a) geschaltet ist und das Bypasselement (4) an einem Endbereich des vierten Modulsegments (2a) angeordnet ist.

10. Solarzellenmodul nach Anspruch 9,
**dadurch gekennzeichnet,**
**dass** zweite und das vierte Modulsegment (2, 2a) und das erste und das dritte Modulsegment (1, 1a) jeweils gegenüberliegend zu einer Mittellinie der vier Modulsegmente (2a) angeordnet sind und das erste und zweite Bypasselement (4, 4a) zwischen zweitem und viertem Modulsegment (2, 2a) angeordnet sind.

11. Solarzellenmodul nach Anspruch 9,
**dadurch gekennzeichnet,**
**dass** die vier Modulsegmente (1, 2, 1a, 2a) in einer Reihe in der Reihenfolge erstes Modulsegment (1), zweites Modulsegment (2), viertes Modulsegment (2a), drittes Modulsegment (1a) nebeneinanderliegend angeordnet sind und das erste und zweite Bypasselement (4, 4a) an einem gemeinsamen Endbereich des zweiten und vierten Modulsegments (2, 2a) angeordnet sind.

12. Solarzellenmodul nach Anspruch 9,
**dadurch gekennzeichnet,**
**dass** die vier Modulsegmente (1, 2, 1a, 2a) in einer Reihe in der Reihenfolge zweites Modulsegment (2), erstes Modulsegment (1), drittes Modulsegment (1a), viertes Modulsegment (2a) nebeneinanderliegend angeordnet sind und das erste Bypasselement (4) an einem Endbereich des zweiten Modulsegments (2) und das zweite Bypasselement (4a) an einem Endbereich des vierten Modulsegments (2a) angeordnet ist.

13. Solarzellenmodul nach einem der vorangegangenen Ansprüche,
**dadurch gekennzeichnet,**
**dass** die Solarzellen des Solarzellenstrings B1 entlang einer geradlinigen Linie angeordnet sind, insbesondere, dass bei jedem String des zweiten Modulsegments (2) und bevorzugt für jeden String des ersten Modulsegments (1) die Solarzellen jeweils entlang einer geradlinigen Linie angeordnet sind.

14. Solarzellenmodul nach einem der vorangegangenen Ansprüche,
**dadurch gekennzeichnet,**
**dass** der Ausgangsstrom der Solarzellenelemente der Gruppe B ein ganzzahliges Vielfaches V, insbesondere bevorzugt das Doppelte, das Dreifache oder das Vierfache des Ausgangsstroms der Solarzellenelemente der Gruppe A beträgt.

15. Solarzellenmodul nach Anspruch 14,
**dadurch gekennzeichnet,**
**dass** bei einer Anzahl m (m = 1,2,3,...) von parallelgeschalteten Solarzellenstrings im zweiten Modulsegment (2) das erste Modulsegment eine Anzahl V*m parallel geschalteter Solarzellenstrings aufweist.

## Claims

1. Solar cell module,
having a plurality of solar cell strings, wherein each solar cell string has a plurality of solar cells connected in series,
**characterised in that**
the solar cell module has a plurality of solar cells of a group A and a plurality of solar cell elements from a group B, wherein the solar cells of the group A have at the optimum working point a smaller output current than the solar cell elements of the group B, that the solar cell module has a first module segment (1) having several solar cell strings connected in parallel, wherein each solar cell string of the first module segment (1) is formed from solar cells of the group A connected in series and
the solar cell module has at least one second module segment (2), connected in series with the first module segment (1), having at least one solar cell string B1 which has a plurality of solar cell elements of the group B connected in series.

2. Solar cell module according to claim 1,
**characterised in that**
group B has solar cell elements (5) in the design of a solar cell, wherein each of these solar cell elements (5) has a greater active solar cell surface comparison to the active surface of each of the solar cells of the group A, in particular each of the solar cell elements (5) of the group B is designed in this way.

3. The system according to one of the preceding claims,
**characterised in that**
group B has solar cell elements (5) which are designed as a parallel circuit of several solar cells, wherein for each of these solar cell elements (5) the sum of the active surfaces of the solar cells connected in parallel is greater than the active surface of each of the solar cells of the group A, wherein solar cell string B1 has at least one solar cell element (5) designed in this manner, in particular that each of the solar cell elements (5) of the solar cell string B1, preferably each solar cell element (5) of the group B is designed in this way.

4. Solar cell module according to claim 3,
**characterised in that**
the solar cells of the solar cell string B1 are arranged in a series in a straight line.

5. The system according to one of the preceding claims,
**characterised in that**
the solar cell module has at least one first bypass element (4) and the first bypass element (4) is connected in parallel to the first and second module segments (1, 2) which are connected in series.

6. The system according to one of the preceding claims,
**characterised in that**
the first and second module segment (1, 2) are arranged next to one another and connected electrically in series at a first edge region, in particular by means of a cross-connector (3), preferably by means of a straight-line cross-connector (3).

7. Solar cell module according to claims 5 and 6,
**characterised in that**
the first bypass element (4) is arranged at a second edge region situated opposite to the first edge region.

8. Solar cell module according to claims 5 to 7,
**characterised in that**
the first bypass element (4) is arranged at an end region of the second module segment (2).

9. The system according to one of the preceding claims,
**characterised in that**
the solar cell module has at least one third module segment (1a) and a fourth module segment (2a) connected in series therewith, wherein the third module segment (1a) has several solar cell strings connected in parallel, wherein each solar cell string of the third module segment (1a) is formed from solar cells of the group A connected in series and the fourth module segment (2a) has at least one solar cell string B2, which has several solar cell elements (5) of the group B connected in series, that the solar cell module has at least one second bypass element (4a) which is connected to the third and fourth module segments (1a, 2a) connected in series and the bypass element (4) is arranged at an end region of the fourth module segment (2a).

10. Solar cell module according to claim 9,
**characterised in that**
the second and the fourth module segment (2, 2a) and the first and the third module segment (1, 1a) are arranged in each case oppositely to a centre line of the four module segments (2a) and the first and second bypass element (4, 4a) are arranged between second and fourth module segment (2, 2a).

11. Solar cell module according to claim 9,
**characterised in that**
the four module segments (1, 2, 1a, 2a) are arranged situated next to one another in a row in the sequence: first module segment (1), second module segment (2), fourth module segment (2a), third module segment (1a), and the first and second bypass element (4, 4a) are arranged at a common end region of the second and fourth module segment (2, 2a).

12. Solar cell module according to claim 9,
**characterised in that**
the four module segments (1, 2, 1a, 2a) are arranged situated next to one another in a row in the sequence: second module segment (2), first module segment (1), third module segment (1a), fourth module segment (2a), and the first bypass element (4) is arranged at an end region of the second module segment (2) and the second bypass element (4a) is arranged at an end region of the fourth module segment (2a).

13. The system according to one of the preceding claims,
**characterised in that**
the solar cells of the solar cell string B1 are arranged along a straight line, in particular that in the case of each string of the second module segment (2) and preferably in the case of each string of the first module segment (1) the solar cells are arranged respectively along a straight line.

14. The system according to one of the preceding claims,
**characterised in that**
the output current of the solar cell elements of the group B is an integer multiple *V,* in particular preferably twice, three times or four times the output current of the solar cell elements of the group A.

15. Solar cell module according to claim 14,
**characterised in that**
in the case of a number m (m = 1,2,3,...) of solar cell strings connected in parallel in the second module segment (2), the first module segment has a number V*m of solar cell strings connected in parallel.

## Revendications

1. Module de cellules solaires
avec une pluralité de chaînes de cellules solaires, dans lequel chaque chaîne de cellules solaires présente une pluralité de cellules solaires montées en série,
**caractérisé en ce que**
le module de cellules solaires présente une pluralité de cellules solaires d'un groupe A et une pluralité d'éléments de cellule solaire d'un groupe B, dans lequel les cellules solaires du groupe A présentent au niveau du point de travail optimal un courant de sortie plus faible que les éléments de cellule solaire du groupe B, **en ce que** le module de cellules solaires présente un premier segment de module (1) avec plusieurs chaînes de cellules solaires montées en parallèle, dans lequel chaque chaîne de cellules solaires du premier segment de module (1) est formée de cellules solaires du groupe A montées en série et
le module de cellules solaires présente au moins un second segment de module (2) monté en série avec le premier segment de module (1), avec au moins une chaîne de cellules solaires B1 qui présente plusieurs éléments de cellule solaire du groupe B montés en série.

2. Module de cellules solaires selon la revendication 1,
**caractérisé en ce que**
le groupe B présente des éléments de cellule solaire (5) réalisés comme cellule solaire, dans lequel chacun de ces éléments de cellule solaire (5) présente une surface de cellule solaire active plus grande par rapport à la surface active de chacune des cellules solaires du groupe A, en particulier **en ce que** chacun des éléments de cellule solaire (5) du groupe B est formé de la sorte.

3. Module de cellules solaires selon l'une quelconque des revendications précédentes,
**caractérisé en ce que**
le groupe B présente des éléments de cellule solaire (5) qui sont formés comme circuit en parallèle de plusieurs cellules solaires, dans lequel pour chacun de ces éléments de cellule solaire (5), la somme des surfaces actives des cellules solaires montées en parallèle est supérieure à la surface active de chacune des cellules solaires du groupe A, dans lequel la chaîne de cellules solaires B1 présente au moins un élément de cellule solaire (5) formé de la sorte, en particulier **en ce que** chacun des éléments de cellule solaire (5) de la chaîne de cellules solaires B1, de préférence chaque élément de cellule solaire (5) du groupe B, est formé de la sorte.

4. Module de cellules solaires selon la revendication 3,
**caractérisé en ce que**
les cellules solaires de la chaîne de cellules solaires B1 sont agencées longitudinalement sur une ligne droite.

5. Module de cellules solaires selon l'une quelconque des revendications précédentes,
**caractérisé en ce que**
le module de cellules solaires présente au moins un premier élément de dérivation (4), et le premier élément de dérivation (4) est monté parallèlement aux premier et second segments de module (1, 2) montés en série.

6. Module de cellules solaires selon l'une quelconque des revendications précédentes,
**caractérisé en ce que**
le premier et le second segments de module (1, 2) sont agencés l'un à côté de l'autre et sont montés électriquement en série au niveau d'une première zone de bord, en particulier au moyen d'un connecteur transversal (3), de préférence au moyen d'un connecteur transversal (3) rectiligne.

7. Module de cellules solaires selon les revendications 5 et 6,
**caractérisé en ce que**
le premier élément de dérivation (4) est agencé au niveau d'une seconde zone de bord opposée à la première zone de bord.

8. Module de cellules solaires selon les revendications 5 à 7,
**caractérisé en ce que**
le premier élément de dérivation (4) est agencé au niveau d'une zone d'extrémité du second segment de module (2).

9. Module de cellules solaires selon l'une quelconque des revendications précédentes,
**caractérisé en ce que**
le module de cellules solaires présente au moins un troisième et un quatrième segment de module (2a) monté en série avec le troisième segment de module (1a), dans lequel le troisième segment de module (1a) présente plusieurs chaînes de cellules solaires montées en parallèle, dans lequel chaque chaîne de cellules solaires du troisième segment de module (1a) est formée de cellules solaires du groupe A montées en série et le quatrième segment de module (2a) présente au moins une chaîne de cellules solaires B2 qui présente plusieurs éléments de cellule solaire (5) du groupe B montés en série, **en ce que** le module de cellules solaires présente au moins un second élément de dérivation (4a) qui est monté parallèlement aux troisième et quatrième segments de module (1a, 2a) montés en série et l'élément de dérivation (4) est agencé au niveau d'une zone d'extrémité du quatrième segment de module (2a).

10. Module de cellules solaires selon la revendication 9,
**caractérisé en ce que**
le deuxième et le quatrième segments de module (2, 2a) et le premier et le troisième segments de module (1, 1a) sont agencés respectivement à l'opposé d'une ligne médiane des quatre segments de module (2a) et le premier et le second éléments de dérivation (4, 4a) sont agencés entre le deuxième et le quatrième segments de module (2, 2a).

11. Module de cellules solaires selon la revendication 9,
**caractérisé en ce que**
les quatre segments de module (1, 2, 1a, 2a) sont agencés sur une ligne dans l'ordre suivant : premier segment de module (1), deuxième segment de module (2), quatrième segment de module (2a), troisième segment de module (1a) les uns à côté des autres, et le premier et le second éléments de dérivation (4, 4a) sont agencés au niveau d'une zone d'extrémité commune du deuxième et du quatrième segments de module (2, 2a).

12. Module de cellules solaires selon la revendication 9,
**caractérisé en ce que**
les quatre segments de module (1, 2, 1a, 2a) sont agencés sur une ligne dans l'ordre suivant : deuxième segment de module (2), premier segment de module (1), troisième segment de module (1a), quatrième segment de module (2a) les uns à côté des autres et le premier élément de dérivation (4) est agencé au niveau d'une zone d'extrémité du deuxième segment de module (2) et le second élément de dérivation (4a) est agencé au niveau d'une zone d'extrémité du quatrième segment de module (2a).

13. Module de cellules solaires selon l'une quelconque des revendications précédentes,
**caractérisé en ce que**
les cellules solaires de la chaîne de cellules solaires B1 sont agencées le long d'une ligne droite, en particulier **en ce que** pour chaque chaîne du deuxième segment de module (2) et de préférence pour chaque chaîne du premier segment de module (1), les cellules solaires sont agencées respectivement le long d'une ligne droite.

14. Module de cellules solaires selon l'une quelconque des revendications précédentes,
**caractérisé en ce que**
le courant de sortie des éléments de cellule solaire du groupe B s'élève à un multiple entier V, en particulier de préférence au double, au triple ou au quadruple du courant de sortie des éléments de cellule solaire du groupe A.

15. Module de cellules solaires selon la revendication 14,
**caractérisé en ce que**
pour un nombre m (m = 1,2,3,...) de chaînes de cellules solaires montées en parallèle dans le deuxième segment de module (2), le premier segment de module présente un nombre V*m de chaînes de cellules solaires montées en parallèle.
